(19) Europäisches Patentamt
European Patent Office
Office européen des brevets

(11) **EP 4 730 646 A1**

# (12) DEMANDE DE BREVET EUROPEEN

(43) Date de publication:
**22.04.2026 Bulletin 2026/17**

(21) Numéro de dépôt: **25209504.7**

(22) Date de dépôt: **17.10.2025**

(51) Classification Internationale des Brevets (IPC):
**H03B 5/06** (2006.01)          **H03B 5/32** (2006.01)

(52) Classification Coopérative des Brevets (CPC):
**H03B 5/32; H03B 5/06;** H03B 2200/0094

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **21.10.2024 FR 2411404**

(71) Demandeur: **STMicroelectronics International N.V.**
**1228 Plan-les-Ouates, Geneva (CH)**

(72) Inventeurs:
• **BRUN, Marine**
**13090 AIX-EN-PROVENCE (FR)**
• **LE FEVRE, Philippe**
**13090 AIX EN PROVENCE (FR)**
• **DANY, Estelle**
**83560 GINASSERVIS (FR)**

(74) Mandataire: **Cabinet Beaumont**
**4, Place Robert Schuman**
**B.P. 1529**
**38025 Grenoble Cedex 1 (FR)**

## (54) OSCILLATEUR ET METHODE D'UTILISATION D'UN OSCILLATEUR

(57) La présente description concerne un oscillateur (400) comprenant :
- une première borne de connexion (130) et une deuxième borne de connexion (135) ;
- un amplificateur (115) relié entre la première borne (130) de connexion et la deuxième borne de connexion (135) ; et
- un circuit (410) configuré pour générer une inductance entre la première borne de connexion (130) et la deuxième borne de connexion (135),
l'oscillateur étant configuré pour être relié à un quartz (150) entre la première borne de connexion (130) et la deuxième borne de connexion (135) et l'amplificateur (115) étant configuré pour piloter le quartz (150).

FIG 4

**Description**

Domaine technique

La présente description concerne de façon générale les oscillateurs et les méthodes d'utilisation des oscillateurs et en particulier les oscillateurs à quartz.

Technique antérieure

Certains oscillateurs sont configurés pour être reliés à un quartz. Le quartz est configuré pour recevoir un signal de la part de l'oscillateur. Le signal a une fréquence égale ou proche d'une fréquence caractéristique du quartz et une énergie qui est par exemple suffisante pour que l'oscillateur puisse démarrer. Cependant, le quartz relié à l'oscillateur peut être l'un parmi des types divers de quartz, chaque type de quartz ayant des paramètres différents. Les paramètres de l'oscillateur sont alors ajustés pour le type de quartz auquel il est connecté pour que l'oscillateur puisse démarrer et fonctionner correctement.

Il existe un besoin pour un oscillateur pouvant s'adapter à divers types de quartz amovibles reliés entre ses bornes et capable par exemple de démarrer sans intervention d'un utilisateur.

Résumé de l'invention

Un mode de réalisation prévoit un oscillateur comprenant : une première borne de connexion et une deuxième borne de connexion ; un amplificateur relié entre la première borne de connexion et la deuxième borne de connexion ; et un circuit configuré pour générer une inductance entre la première borne de connexion et la deuxième borne de connexion, l'oscillateur étant configuré pour être relié à un quartz entre la première borne de connexion et la deuxième borne de connexion et l'amplificateur étant configuré pour piloter le quartz.

Selon un mode de réalisation, l'inductance est variable.

Selon un mode de réalisation, l'oscillateur comprend en outre un circuit de mesure configuré pour mesurer une capacitance entre la première borne de connexion et la deuxième borne de connexion, le circuit étant configuré pour ajuster la valeur d'inductance sur la base de la mesure de la capacitance.

Selon un mode de réalisation, le circuit est configuré pour générer l'inductance pour être égale à l'inverse du produit de la capacitance mesurée et de la pulsation de l'oscillateur au carré, à 10% près.

Selon un mode de réalisation, l'oscillateur est configuré pour générer un signal de sortie à une fréquence inférieure à 1 MHz.

Selon un mode de réalisation, le circuit comprend un ou plusieurs amplificateurs opérationnels de transconductance.

Selon un mode de réalisation, la transconductance d'un ou plusieurs amplificateurs opérationnels de transconductance est variable.

Un autre mode de réalisation prévoit un procédé d'utilisation d'un oscillateur, comprenant : relier un quartz entre une première borne de connexion et une deuxième borne de connexion de l'oscillateur ; piloter le quartz par un amplificateur relié entre la première borne de connexion et la deuxième borne de connexion ; et générer une inductance entre la première borne de connexion et la deuxième borne de connexion par un circuit.

Selon un mode de réalisation, l'inductance est variable.

Selon un mode de réalisation, le procédé comprend en outre, avant la génération de l'inductance : mesurer une capacitance entre la première borne de connexion et la deuxième borne de connexion, la génération de la valeur de l'inductance comprenant l'ajustement de l'inductance en fonction de la valeur de la capacitance mesurée.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente un exemple d'oscillateur à quartz ;

la figure 2 est un graphe d'une impédance de l'oscillateur de la figure 1 en fonction de sa transconductance ;

la figure 3 est un graphe de l'impédance de l'oscillateur de la figure 1 en fonction de sa transconductance et en fonction d'un paramètre d'un quartz relié à l'oscillateur ;

la figure 4 représente un exemple d'oscillateur à quartz, selon un mode de réalisation de la présente description ;

la figure 5A, la figure 5B, la figure 5C et la figure 5D représentent des exemples d'un circuit inductance d'un circuit de compensation de l'oscillateur à quartz de la figure 4, selon un mode de réalisation de la présente description ; et

la figure 6 est un graphe de l'impédance de l'oscillateur de la figure 4 en fonction de sa transconductance et en fonction d'un paramètre d'un quartz relié à l'oscillateur, selon un mode de réalisation de la présente description.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, le fonctionnement d'un oscillateur est supposé connu de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

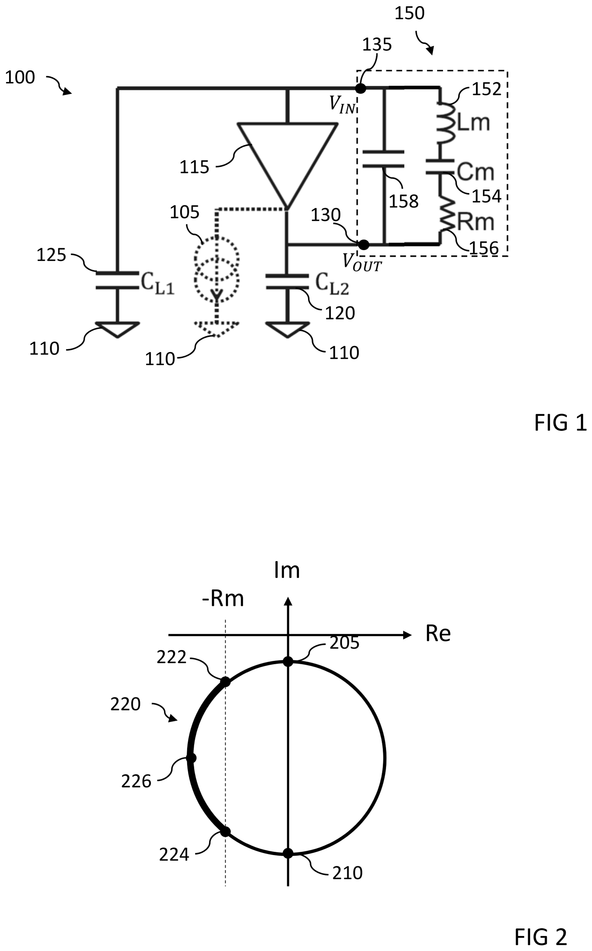

La figure 1 représente un exemple d'oscillateur 100 à quartz.

L'oscillateur 100 est configuré pour être relié à un quartz 150, le quartz 150 étant amovible et externe à l'oscillateur 100. Le quartz 150 est par exemple configuré pour filtrer un signal et transmettre des signaux ayant une fréquence égale ou proche d'une fréquence caractéristique du quartz 150.

L'oscillateur 100 comprend par exemple un générateur de courant 105 configuré pour générer un courant alternatif $I_{AC}$. Le générateur de courant 105 comprend une première borne de connexion, par exemple reliée à un rail de masse 110, et comprend une deuxième borne de connexion, par exemple reliée à une première borne de connexion d'un amplificateur de courant 115. L'amplificateur de courant 115 est par exemple configuré pour piloter le quartz 150. L'amplificateur de courant 115 comprend par exemple une résistance interne, non illustrée en Figure 1. La première borne de connexion de l'amplificateur de courant 115 est par exemple en outre reliée à un premier condensateur 120 (« $C_{L2}$ ») ayant une capacité électrique $C_{L2}$. L'amplificateur de courant 115 comprend une deuxième borne de connexion reliée par exemple à un deuxième condensateur 125 (« $C_{L1}$ ») ayant une capacité électrique $C_{L1}$. Le premier 120 et le deuxième 125 condensateurs sont par exemple en outre reliés au rail de masse 110. Le premier 120 et le deuxième 125 condensateurs sont par exemple externes à l'oscillateur 115 et configurés pour moduler et ajuster la fréquence caractéristique du quartz 150.

L'oscillateur 100 a une première borne de connexion 130, reliée à la première borne de connexion de l'amplificateur de courant 115, et une deuxième borne de connexion 135, reliée à la deuxième borne de connexion de l'amplificateur de courant 115.

L'oscillateur 100 est configuré pour être relié au quartz 150, le quartz 150 étant branché entre la première 130 et la deuxième 135 bornes de connexion de l'oscillateur 100. Le quartz 150 est par exemple choisi par un utilisateur, et le type de quartz, et notamment ses paramètres, ne sont pas fixés lors de la conception et fabrication de l'oscillateur 100. Le quartz 150 est par exemple choisi en fonction de sa robustesse, de sa consommation, de sa disponibilité, de son prix, de sa sensibilité aux composants externes, etc.

Comme illustré en figure 1, le quartz 150 est par exemple modélisé par une inductance 152, ayant une valeur d'inductance Lm, connectée en série à un troisième condensateur 154, ayant une capacité Cm, et connectée en série à une résistance 156, ayant une résistance Rm. L'inductance 152, le condensateur 154 et la résistance 156 sont par exemple reliés entre la première 130 et la deuxième 135 bornes de connexion de l'oscillateur 100 et reliés en parallèle avec un quatrième condensateur 158, ayant une capacité $C_0$. Le condensateur 158 est relié entre la première 130 et la deuxième 135 bornes de connexion de l'oscillateur 100.

L'oscillateur 100 et le quartz 150 sont configurés pour respecter certaines conditions pour que l'oscillateur 100 démarre et fonctionne de façon stable. L'oscillateur 100 est configuré pour alimenter le quartz 150 avec suffisamment d'énergie au démarrage et durant une période transitoire suivant le démarrage. En particulier, une transconductance $g_m$

3

de l'oscillateur 100 est par exemple configurée pour être supérieure à la conductance du quartz 150, la transconductance $g_m$ de l'oscillateur 100 étant définie par :
[Math 1]

$$g_m = \left.\frac{\partial I_{OUT}}{\partial V_{IN}}\right|_{V_{OUT}=c} \qquad (1)$$

avec $I_{OUT}$ un courant mesuré à la première borne de connexion 130 de l'oscillateur 100, $V_{IN}$ une tension appliquée entre le rail de tension 110 et la deuxième borne de connexion 135 de l'oscillateur 100, $V_{OUT}$ une tension appliquée entre le rail de tension 110 et la première borne de connexion 130 de l'oscillateur 100 et c une constante.

Cependant, l'oscillateur 100 est configuré pour ne pas recevoir une énergie trop importante au démarrage et pour que sa transconductance $g_m$ ne soit pas trop élevée, sinon une boucle d'oscillation de l'oscillateur 100 sature et l'oscillateur 100 ne démarre pas.

On note $g_{mc}$ la transconductance du quartz 150. La transconductance $g_{mc}$ est par exemple définie par :
[Math 2]

$$g_{mc} = 4 \cdot Rm \cdot (2\pi F)^2 \cdot \left(C_0 + \frac{C_{L1} \cdot C_{L2}}{C_{L1}+C_{L2}}\right)^2 = 4 \cdot Rm \cdot (2\pi F)^2 \cdot (C_0 + C_L)^2 \qquad (2)$$

avec F une fréquence d'utilisation de l'oscillateur 100 et $C_L$ une capacité définie par : $C_L = \frac{C_{L1} \cdot C_{L2}}{C_{L1}+C_{L2}}$.

La fréquence d'utilisation F est par exemple comprise entre 1 kHz (inclus) et 50 Mhz (inclus), et dans un exemple entre 30 kHz (inclus) et 35 kHz (inclus) et de préférence proche de 32,768 kHz.

La transconductance $g_{mc}$ du quartz 150 est par exemple inférieure à une valeur $g_{mcmax}$ pour que l'oscillateur démarre et fonctionne correctement.

Le premier 120 et le deuxième 125 condensateurs sont par exemple choisis pour régler la fréquence du quartz 150. La valeur de $C_L$ dépend donc du quartz 150 utilisé.

La figure 2 est un graphe d'une impédance Zc de l'oscillateur 100 de la figure 1 en fonction de sa transconductance $g_m$, définie par l'équation (1), représentée dans un plan complexe.

L'impédance Zc de l'oscillateur 100 est définie par :
[Math 3]

$$Zc = \frac{V_{OUT}}{I_{OUT}} \qquad (3)$$

avec $I_{OUT}$ le courant mesuré à la première borne de connexion 130 de l'oscillateur 100 et $V_{OUT}$ la tension appliquée entre le rail de tension 110 et la première borne de connexion 130 de l'oscillateur 100.

Dans le plan complexe, l'impédance Zc de l'oscillateur 100 est par exemple un ovale, centré sur l'axe des imaginaires (« Im »). La partie imaginaire de l'impédance Zc est par exemple maximale lorsque la transconductance $g_m$ est égale à 0 (point 205). La partie imaginaire de l'impédance Zc est par exemple minimale lorsque la transconductance $g_m$ est infinie (point 210). La partie réelle de l'impédance Zc est par exemple positive lorsque la transconductance $g_m$ est inférieure à 0 et la partie réelle de l'impédance Zc est par exemple négative lorsque la transconductance $g_m$ est supérieure à 0.

L'oscillateur 100 est par exemple stable 220 et peut par exemple démarrer si la partie réelle de l'impédance Zc est inférieure à -Rm, soit entre les points 222 et 224.

Le point 224 correspond par exemple à l'impédance Zc lorsque la transconductance $g_m$ est égale à $g_{mcmax}$. Un point 226 compris entre les points 222 et 224 correspond par exemple à une valeur optimale $g_{opt}$ de la transconductance $g_m$.

La valeur optimale $g_{opt}$ de la transconductance $g_m$ est par exemple définie par :
[Math 4]

$$g_{opt} = 2\pi F \cdot \left(C_{L1} + C_{L2} + \frac{C_{L1}C_{L2}}{C_0}\right). \qquad (4)$$

Lorsque $C_{L1}$ et $C_{L2}$ sont égaux, $g_{opt}$ est défini par :
[Math 5]

$$g_{opt} = 4 \cdot 2\pi F \cdot (C_L + \frac{C_{L^2}}{C_0}).\qquad(5)$$

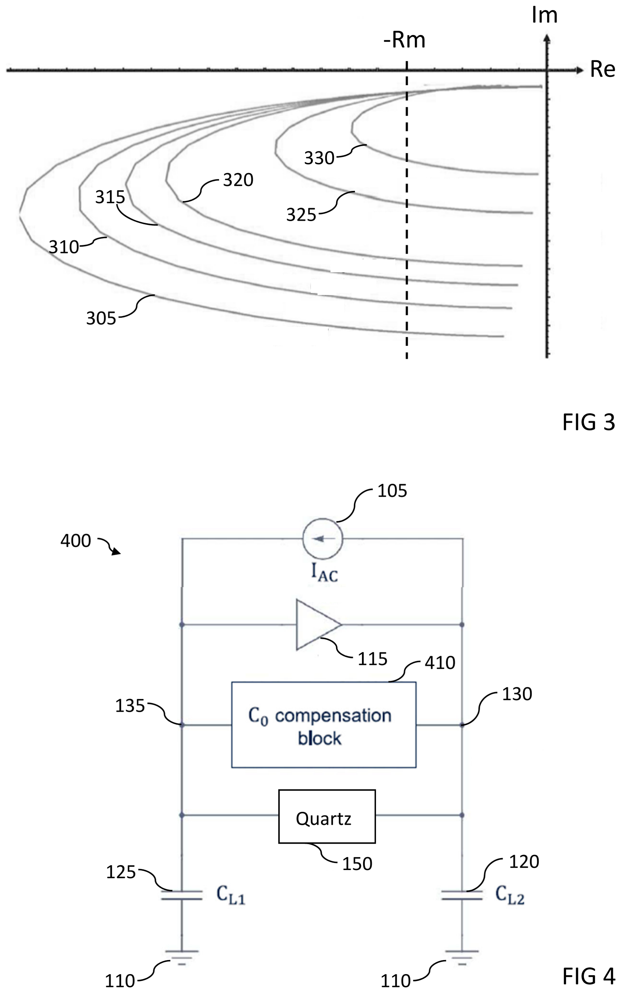

La figure 3 est un graphe de l'impédance Zc de l'oscillateur 100 de la figure 1 en fonction de sa transconductance $g_m$ et d'un paramètre du quartz 150 relié à l'oscillateur.

En particulier, chacune des courbes 305 à 330 de la figure 3 représente l'impédance Zc en fonction de $g_m$, lorsque le quartz 150, relié à l'oscillateur 100, a respectivement le quatrième condensateur 158 ayant une capacité de 0,5 pF, 1 pF, 1,1 pF, 1,2 pF, 2 pF et 3 pF. Une plage de transconductance $g_m$ compatible avec un démarrage de l'oscillateur 100, par exemple correspondant à une impédance Zc ayant une partie réelle inférieure à -Rm, varie avec la capacité $C_0$ générée par le quartz 150.

Plus la capacité $C_0$ du condensateur 158 est faible, plus la plage de transconductance $g_m$ compatible avec un démarrage de l'oscillateur 100 est grande. Il est donc préférable que la capacité $C_0$ soit faible.

La figure 4 représente un exemple d'oscillateur 400 à quartz selon un mode de réalisation de la présente description.

Certains éléments de la figure 4 sont similaires à des éléments de la figure 1. Ces éléments sont référencés avec les mêmes références et ne sont pas décrits à nouveau en détail.

Selon un mode de réalisation, l'oscillateur 400 est un oscillateur externe à faible vitesse (de l'anglais « Low Speed External », LSE) et oscille à une fréquence par exemple comprise entre 1 kHz (inclus) et 35 kHz (inclus) et dans un exemple entre 30 kHz (inclus) et 35 kHz (inclus), de préférence proche de 32,768 kHz.

Selon d'autres modes de réalisation, l'oscillateur 400 est un oscillateur externe à grande vitesse (de l'anglais « High Speed External », HSE) et oscille à une fréquence par exemple comprise entre 4 MHz (inclus) et 50 MHz (inclus).

L'oscillateur 400 se distingue de l'oscillateur 100 de la figure 1 par l'ajout d'un circuit de compensation 410 (« $C_0$ compensation block »).

Le circuit de compensation 410 est par exemple relié entre la première 130 et la deuxième 135 bornes de connexion de l'oscillateur 400. Le circuit de compensation 410 est par exemple un circuit configuré pour générer une inductance L entre les bornes 130 et 135. L'inductance L générée par le circuit de compensation 410 est en parallèle avec le quartz 150. En particulier, l'inductance L générée par le circuit de compensation 410 est par exemple en parallèle avec le quatrième condensateur 158 du quartz 150. L'inductance L compense au moins partiellement la capacité $C_0$.

Selon un mode de réalisation, le circuit de compensation 410 comprend une inductance reliée entre la première 130 et la deuxième 135 bornes de connexion de l'oscillateur 400.

Selon un mode de réalisation, le circuit de compensation 410 et le quartz 150 forment ensemble un circuit équivalent à un quartz ayant un quatrième condensateur 158 configuré pour générer une capacité équivalente $C_0'$ inférieure à la capacité $C_0$ du condensateur 158 du quartz.

Selon un mode de réalisation, le circuit de compensation 410 est configuré pour que l'inductance L générée ait une valeur variable. Par exemple, le circuit 410 comprend un circuit de mesure, non illustré, configuré pour effectuer une mesure entre la première 130 et la deuxième 135 bornes de connexion de l'oscillateur 400, par exemple une mesure de capacité. Par exemple, le circuit de mesure comprend un condensateur et est configuré pour évaluer une capacité entre la première 130 et la deuxième 135 bornes de connexion en mesurant le temps de charge ou de décharge du condensateur. Par exemple, le circuit 410 comprend en outre un circuit inductance, non illustré en figure 4, configuré pour générer une inductance variable dont la valeur varie en fonction de la valeur mesurée entre les bornes de connexion.

Selon un mode de réalisation, le circuit 410 est configuré pour générer l'inductance L variable, L étant égale à $1/(Cw^2)$ avec C une capacité mesurée par le circuit de mesure et w une pulsation, par exemple égale à $2 \cdot \pi \cdot F$ avec F la fréquence d'utilisation de l'oscillateur 100.

Par exemple, le circuit 410 est configuré pour générer l'inductance L variable et configuré pour que l'inductance équivalente $C_0'$ soit inférieure à 1 pF, et par exemple approximativement égale à 0,5 pF. Par exemple, le circuit 410 est configuré pour que l'inductance équivalente $C_0'$ soit programmable par un utilisateur.

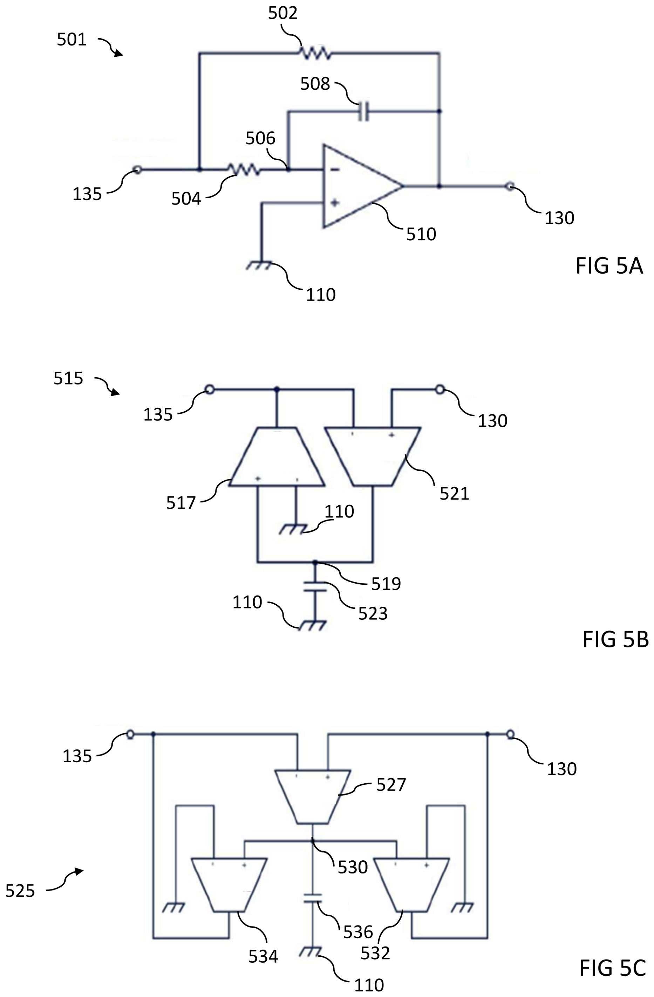

Les figures 5A à 5D représentent des exemples d'un circuit d'inductance mettant en œuvre le circuit de compensation 410 de l'oscillateur 400 de la figure 4, selon un mode de réalisation de la présente description. Le circuit d'inductance est par exemple configuré pour être équivalent à une inductance ayant une valeur d'inductance variable.

La figure 5A représente un premier circuit 501. Le circuit 501 comprend par exemple une première résistance 502, ayant une résistance R1, reliée, de préférence connectée, entre la première 130 et la deuxième 135 bornes de connexion de l'oscillateur 400 de la figure 4, et comprend par exemple une deuxième résistance 504, ayant une résistance R2, reliée, de préférence connectée, entre la deuxième borne de connexion 135 et un nœud de connexion intermédiaire 506. Le circuit 501 comprend en outre un condensateur 508, ayant une capacité C1, relié, de préférence connecté, entre la première borne de connexion 130 et le nœud de connexion intermédiaire 506 et comprend en outre un amplificateur opérationnel 510 comprenant une entrée positive reliée, de préférence connectée, au rail de masse 110, une entrée négative reliée, de préférence connectée, au nœud de connexion intermédiaire 506 et une sortie reliée, de préférence connectée, à la première borne de connexion 130.

Le circuit 501 est par exemple configuré pour générer une inductance équivalente L définie par : L=C1·R1·R2. Au moins une parmi la résistance 502 et la résistance 504 est par exemple une résistance variable contrôlée par le circuit de mesure, non illustré, du circuit de compensation 410.

La figure 5B représente un deuxième circuit 515. Le circuit 515 comprend par exemple un premier amplificateur opérationnel de transconductance (OTA, de l'anglais « operational transconductance amplifier ») 517, configuré pour générer une transconductance $g_{m1}$, comprenant par exemple une entrée négative reliée, de préférence connectée, au rail de masse 110, une entrée positive reliée, de préférence connectée, à un nœud de connexion intermédiaire 519 et une sortie reliée, de préférence connectée, à la deuxième borne de connexion 135. Le circuit 515 comprend en outre, par exemple, un deuxième OTA 521, configuré pour générer une transconductance $g_{m2}$, comprenant par exemple une entrée négative reliée, de préférence connectée, à la deuxième borne de connexion 135, une entrée positive reliée, de préférence connectée, à la première borne de connexion 130 et une sortie reliée, de préférence connectée, au nœud de connexion intermédiaire 519. Le circuit 515 comprend en outre un condensateur 523, ayant une capacité C1, relié, de préférence connecté, entre le nœud de connexion intermédiaire 519 et le rail de masse 110.

Le circuit 515 est par exemple configuré pour générer une inductance équivalente L définie par : $L=\dfrac{C1}{gm1 \cdot gm2}$.

Au moins un parmi l'OTA 517 et l'OTA 521 est par exemple configuré pour générer une transconductance variable contrôlée par le circuit de mesure, non illustré, du circuit de compensation 410. Par exemple, au moins une des transconductances $g_{m1}$ et $g_{m2}$ est contrôlée par un courant. Le courant est appliqué au circuit 515, par exemple entre les bornes de connexion 130 et 135, pour polariser le circuit 515.

La figure 5C représente un troisième circuit 525. Le circuit 525 comprend par exemple un premier OTA 527, configuré pour générer une transconductance $g_{m1}$, comprenant par exemple une entrée négative reliée, de préférence connectée, à la deuxième borne de connexion 135, une entrée positive reliée, de préférence connectée, à la première borne de connexion 130 et une sortie reliée, de préférence connectée, à un nœud de connexion intermédiaire 530. Le circuit 525 comprend en outre, par exemple, un deuxième OTA 532, configuré pour générer une transconductance $g_{m2}$, comprenant par exemple une entrée négative reliée, de préférence connectée, au nœud de connexion intermédiaire 530, une entrée positive reliée, de préférence connectée, au rail de masse 110 et une sortie reliée, de préférence connectée, à la première borne de connexion 130. Le circuit 525 comprend en outre, par exemple, un troisième OTA 534, configuré pour générer la transconductance $g_{m2}$, comprenant par exemple une entrée positive reliée, de préférence connectée, au nœud de connexion intermédiaire 530, une entrée négative reliée, de préférence connectée, au rail de masse 110 et une sortie reliée, de préférence connectée, à la deuxième borne de connexion 135. Le circuit 525 comprend en outre un condensateur 536, ayant une capacité C1, relié, de préférence connecté, entre le nœud de connexion intermédiaire 530 et le rail de masse 110.

Le circuit 525 est par exemple configuré pour générer une inductance équivalente L définie par : $L=\dfrac{C1}{gm1 \cdot gm2}$.

Au moins un parmi l'OTA 527, l'OTA 532 et l'OTA 534 est par exemple configuré pour générer une transconductance variable contrôlée par le circuit de mesure, non illustré, du circuit de compensation 410. Par exemple, au moins une des transconductances $g_{m1}$ et $g_{m2}$ est contrôlée par un courant. Le courant est appliqué au circuit 515, par exemple entre les bornes de connexion 130 et 135, pour polariser le circuit 515.

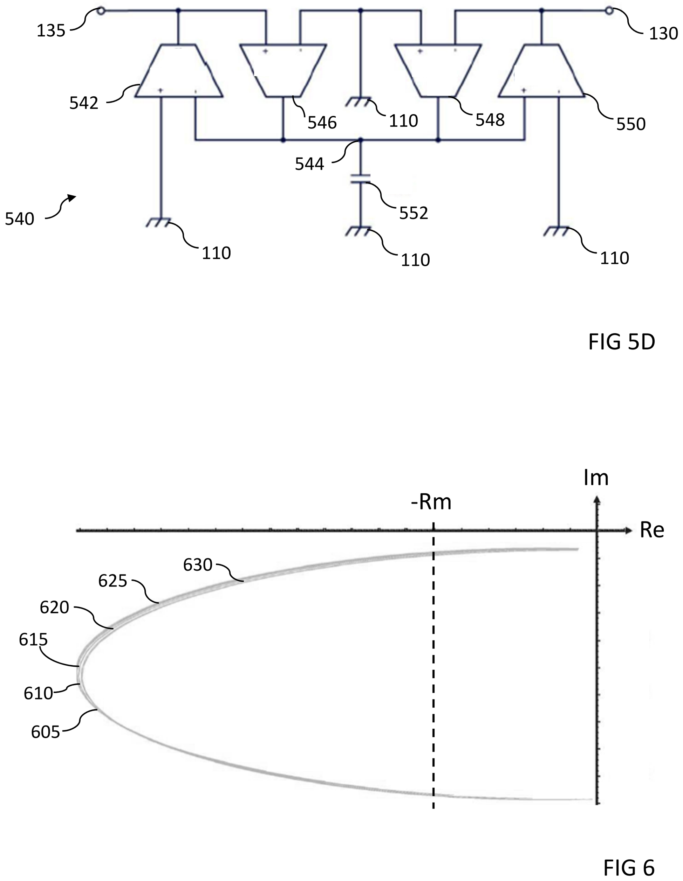

La figure 5D représente un quatrième circuit 540. Le circuit 540 comprend par exemple un premier OTA 542, configuré pour générer une transconductance $g_{m1}$, comprenant par exemple une entrée positive reliée, de préférence connectée, au rail de masse 110, une entrée négative reliée, de préférence connectée, à un nœud de connexion intermédiaire 544 et une sortie reliée, de préférence connectée, à la deuxième borne de connexion 135. Le circuit 540 comprend en outre, par exemple, un deuxième OTA 546, configuré pour générer une transconductance $g_{m2}$, comprenant par exemple une entrée positive reliée, de préférence connectée, à la deuxième borne de connexion 135, une entrée négative reliée, de préférence connectée, au rail de masse 110 et une sortie reliée, de préférence connectée, au nœud de connexion intermédiaire 544. Le circuit 540 comprend en outre, par exemple, un troisième OTA 548, configuré pour générer la transconductance $g_{m2}$, comprenant par exemple une entrée positive reliée, de préférence connectée, au rail de masse 110, une entrée négative reliée, de préférence connectée, à la première borne de connexion 130 et une sortie reliée, de préférence connectée, au nœud de connexion intermédiaire 544. Le circuit 540 comprend en outre, par exemple, un quatrième OTA 550, configuré pour générer la transconductance $g_{m1}$, comprenant par exemple une entrée positive reliée, de préférence connectée, au nœud de connexion intermédiaire 544, une entrée négative reliée, de préférence connectée, au rail de masse 110 et une sortie reliée, de préférence connectée, à la première borne de connexion 130. Le circuit 540 comprend en outre, par exemple, un condensateur 552, ayant une capacité C1, relié, de préférence connecté, entre le nœud de connexion intermédiaire 544 et le rail de masse 110.

Le circuit 540 est par exemple configuré pour générer une inductance équivalente L définie par : $L = \dfrac{C1}{gm1 \cdot gm2}$.

Au moins un parmi l'OTA 542, l'OTA 544, l'OTA 548 et l'OTA 550 est par exemple configuré pour générer une transconductance variable contrôlée par le circuit de mesure, non illustré, du circuit de compensation 410. Par exemple, au moins une des transconductances $g_{m1}$ et $g_{m2}$ est contrôlée par un courant. Le courant est appliqué au circuit 515, par exemple entre les bornes de connexion 130 et 135, pour polariser le circuit 515.

La figure 6 est un graphe de l'impédance de l'oscillateur 400 de la figure 4 en fonction de sa transconductance et du quartz 150 relié à l'oscillateur, selon un mode de réalisation de la présente description.

En particulier, chacune des courbes 605 à 630 représente l'impédance Zc en fonction de $g_m$, lorsque l'oscillateur 400 est relié au quartz 150 ayant respectivement le quatrième condensateur 158 configuré pour générer 0,5 pF, 1 pF, 1,1 pF, 1,2 pF, 2 pF et 3 pF. Dans l'exemple de la figure 6, l'oscillateur 400 est configuré pour que le circuit de compensation 410 génère la valeur d'inductance L variable de sorte que le circuit de compensation 410 et le quartz 150 soient ensemble équivalent à un quartz similaire au quartz 150 ayant une capacité équivalente $C_0'$ approximativement égale à 0,5 pF. Chacune des courbes 605 à 630 varie relativement peu avec la valeur de $C_0$ du quartz 150. Une plage de transconductance $g_m$ compatible avec un démarrage de l'oscillateur 400, par exemple correspondant à une impédance Zc ayant une partie réelle inférieure à -Rm, varie relativement peu avec la capacité $C_0$ générée par le quartz 150.

Un avantage d'avoir un oscillateur comprenant circuit de compensation configuré pour générer une inductance est de compenser au moins partiellement la capacité $C_0$ du quartz 150. Un quartz équivalent avec une valeur de capacité équivalente $C_0'$ inférieure à $C_0$ est obtenue. Cela permet par exemple un démarrage plus rapide de l'oscillateur et/ou d'améliorer des performances de l'oscillateur, par exemple de réduire la consommation de l'oscillateur. Un autre avantage de la présence du circuit de compensation 410 configuré pour générer une inductance est de réduire des contraintes sur la transconductance $g_m$ de l'oscillateur. En effet, la plage de valeurs compatibles avec un démarrage et un fonctionnement stable de l'oscillateur est plus grande pour une valeur de $C_0'$ plus faible. En pratique, une plus grande variété de types de quartz est alors compatible avec l'oscillateur, sans intervention d'un utilisateur et sans modification des paramètres de l'oscillateur. Cela facilite l'utilisation de l'oscillateur par des utilisateurs. Cela réduit également le nombre de répétitions d'un test à effectuer sur l'oscillateur, qui n'aura par exemple pas à être répété pour chacun des modes de l'oscillateur, ce qui réduit également un risque d'erreur.

Un avantage d'avoir un oscillateur comprenant un circuit de compensation configuré pour générer une inductance variable est d'avoir un oscillateur configuré pour s'adapter à un nombre relativement grand de types de quartz de façon autonome, sans l'intervention d'un utilisateur. L'oscillateur a par exemple un seul mode compatible avec une grande variété de types de quartz. L'utilisateur n'a pas besoin de comprendre le fonctionnement de l'oscillateur pour s'en servir. Le démarrage de l'oscillateur est également plus rapide et l'oscillateur est par exemple moins coûteux.

Bien que différents circuits configurés pour générer une inductance soient décrits en relation avec les figures 5A à 5D, d'autres circuits sont possibles et à la portée de la personne du métier. Par exemple, en plus du circuit configuré pour générer une inductance, le circuit de compensation pourrait comprend un circuit configuré pour générer une compensation à la capacité $C_0$.

L'oscillateur 400 est par exemple compris dans un circuit intégré comprenant par exemple également un microcontrôleur, par exemple un microcontrôleur radiofréquence, ou un microprocesseur.

L'oscillateur 400 est par exemple compris dans un compteur en temps réel (de l'anglais « real-time counter », RTC).

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les oscillateurs 100 et 400 représentent des exemples de circuits d'un oscillateur à quartz et d'autres variantes sont à la portée de la personne du métier.

Enfin, la mise en oeuvre pratique des modes de réalisation et variantes décrits est à la portée de la personne du métier à partir des indications fonctionnelles données ci-dessus.

## Revendications

1. Oscillateur (400) comprenant :

   - une première borne de connexion (130) et une deuxième borne de connexion (135) ;
   - un amplificateur (115) relié entre la première borne (130) de connexion et la deuxième borne de connexion (135) ; et
   - un circuit (410) configuré pour générer une inductance entre la première borne de connexion (130) et la deuxième borne de connexion (135),

l'oscillateur étant configuré pour être relié à un quartz (150) entre la première borne de connexion (130) et la deuxième borne de connexion (135) et l'amplificateur (115) étant configuré pour piloter le quartz (150).

2. Oscillateur selon la revendication 1, dans lequel l'inductance est variable.

3. Oscillateur selon la revendication 2, comprenant en outre un circuit de mesure configuré pour mesurer une capacitance entre la première borne de connexion (130) et la deuxième borne de connexion (135), le circuit étant configuré pour ajuster la valeur d'inductance sur la base de la mesure de la capacitance.

4. Oscillateur selon la revendication 3, dans lequel le circuit est configuré pour générer l'inductance pour être égale à l'inverse du produit de la capacitance mesurée et de la pulsation de l'oscillateur au carré, à 10% près.

5. Oscillateur selon l'une quelconque des revendications 1 à 4, configuré pour générer un signal de sortie à une fréquence inférieure à 1 MHz.

6. Oscillateur selon l'une quelconque des revendications 1 à 5, dans lequel le circuit (410) comprend un ou plusieurs amplificateurs opérationnels de transconductance.

7. Oscillateur selon la revendication 6, dans lequel la transconductance d'un ou plusieurs amplificateurs opérationnels de transconductance est variable.

8. Procédé d'utilisation d'un oscillateur (400), comprenant :

- relier un quartz (150) entre une première borne de connexion (130) et une deuxième borne de connexion (135) de l'oscillateur ;
- piloter le quartz (150) par un amplificateur (115) relié entre la première borne de connexion et la deuxième borne de connexion ; et
- générer une inductance entre la première borne de connexion et la deuxième borne de connexion par un circuit (410).

9. Procédé selon la revendication 8, dans lequel l'inductance est variable.

10. Procédé selon la revendication 9, comprenant en outre, avant la génération de l'inductance :

- mesurer une capacitance entre la première borne de connexion (130) et la deuxième borne de connexion (135), la génération de la valeur de l'inductance comprenant l'ajustement de l'inductance en fonction de la valeur de la capacitance mesurée.

FIG 1

FIG 2

FIG 3

FIG 4

FIG 5A

FIG 5B

FIG 5C

FIG 5D

FIG 6

Europäisches
Patentamt

European
Patent Office

Office européen
des brevets

**RAPPORT DE RECHERCHE EUROPEENNE**

Numéro de la demande

EP 25 20 9504

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 114 024 505 A (UNIV SOUTH CHINA TECH) 8 février 2022 (2022-02-08) | 1,2,5-9 | INV. H03B5/06 |
| Y | * figure 2 * | 10 | H03B5/32 |
| A | | 3,4 | |
| | ----- | | |
| X | US 2019/109561 A1 (BAHR BICHOY [US] ET AL) 11 avril 2019 (2019-04-11) * figure 6 * | 1,8 | |
| | ----- | | |
| X | DE 25 49 943 A1 (SENNHEISER ELECTRONIC) 12 mai 1977 (1977-05-12) * figure 2 * | 1,8 | |
| | ----- | | |
| Y | CN 115 955 196 A (CHENGDU SHIYUAN FREQUENCY CONTROL TECH CO LTD) 11 avril 2023 (2023-04-11) * page 2, alinéa 2; figure 1a * | 10 | |
| | ----- | | |

**DOMAINES TECHNIQUES RECHERCHES (IPC)**

H03B

Le présent rapport a été établi pour toutes les revendications

| Lieu de la recherche | Date d'achèvement de la recherche | Examinateur |
|---|---|---|
| Munich | 10 mars 2026 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 20 9504

10-03-2026

| Document brevet cité au rapport de recherche | Date de publication | Membre(s) de la famille de brevet(s) | Date de publication |
|---|---|---|---|
| CN 114024505 A | 08-02-2022 | AUCUN | |
| US 2019109561 A1 | 11-04-2019 | US 2019109561 A1 | 11-04-2019 |
| | | WO 2019071066 A1 | 11-04-2019 |
| DE 2549943 A1 | 12-05-1977 | AUCUN | |
| CN 115955196 A | 11-04-2023 | AUCUN | |

EPO FORM P0460

Pour tout renseignement concernant cette annexe : voir Journal Officiel de l'Office européen des brevets, No.12/82